# EUROPÄISCHE PATENTSCHRIFT

(11) **EP 0 956 584 B1**
(45) Veröffentlichungstag und Bekanntmachung des Hinweises auf die Patenterteilung: **12.06.2002**
(21) Anmeldenummer: 97916392.0
(22) Anmeldetag: 26.03.1997
(51) Int. Cl.: H01L 21/00

(54) **VERFAHREN UND VORRICHTUNG ZUM TROCKNEN VON SUBSTRATEN**
PROCESS AND DEVICE FOR DRYING OF SUBSTRATES
PROCEDE ET DISPOSITIF DE SECHAGE DE SUBSTRATS

(30) Priorität: 04.04.1996 DE 19613620
(43) Veröffentlichungstag der Anmeldung: 17.11.1999
(73) Patentinhaber: STEAG MicroTech GmbH, 72124 Pliezhausen (DE)
(72) Erfinder: WEBER, Martin, D-78073 Bad Dürrheim (DE)
(74) Vertreter: Wagner, Karl H., Dipl.-Ing.
(86) Internationale Anmeldenummer: EP9701537
(87) Internationale Veröffentlichungsnummer: WO9738438

(56) Entgegenhaltungen:
- EP-A- 0 328 746
- EP-A- 0 385 536
- DE-C- 3 733 670
- US-A- 5 556 479

## Beschreibung

Die vorliegende Erfindung bezieht sich auf ein Verfahren und eine Vorrichtung zum Trocknen von Substraten.

Aus EP-A-0 385 536 ist ein Verfahren und eine Vorrichtung zum Trocknen von Substraten nach einer Behandlung in einer Flüssigkeit bekannt. Bei dem aus dieser Druckschrift bekannten Verfahren werden Substrate für einige Zeit in einem Bad, das eine Flüssigkeit enthält, behandelt, und dann daraus entnommen, und zwar so langsam, daß praktisch die gesamte Flüssigkeit in dem Bad verbleibt. Dabei werden die Substrate von der Flüssigkeit direkt in Kontakt mit einem Dampf gebracht. Der Dampf kondensiert nicht auf den Substraten und mischt sich mit der Flüssigkeit, wobei die Mischung eine geringere Oberflächenspannung als die Flüssigkeit besitzt. Dieses Verfahren ist jedoch in der Praxis sehr aufwendig, da Dampf erforderlich ist, dieser entsorgt werden muß und insbesondere Zuführleitungen und Auslaßdüsen für den Dampf bereitgestellt werden müssen.

Aus der US-A-4 722 752 ist eine Vorrichtung und ein Verfahren zum Reinigen und Trocknen von scheibenförmigen Substraten, beispielsweise von Halbleiter-Wafern bekannt, bei der bzw. bei dem die im Substrat gespeicherte Restwärme zur Einstellung eines Oberflächenspannungsgradienten ausgenutzt wird. Eine Zufuhr von Wärme von außen zur Verbesserung oder Beschleunigung des Trocknungsvorgangs ist nicht vorgesehen.

Die US-A-4 902 350 zeigt und beschreibt eine Vorrichtung und ein Verfahren zum Reinigen und Trocknen von Substraten, wobei an der Oberfläche der Flüssigkeit dem Substrat beim Ausbringen Energie in Form von Ultraschall zugeführt wird. Die zugeführte Energie dient jedoch nicht der Trocknung sondern der Reinigung.

Das aus der US-A-5 368 649 bekannte Wasch- und Trocknungsverfahren für mechanische oder elektronische Bauteile sowie Linsen verwendet zur Verbesserung des Trocknungsverfahrens eine Flüssigkeit, die unter einem über dem Atmosphärendruck liegenden Druck gehalten wird. Die Waschflüssigkeit wird über den bei Atmosphärendruck bestehenden Siedepunkt erhitzt. Für den Trockenvorgang wird das Werkstück in eine Trocknungskammer gebracht, in der eine plötzliche Dekompression stattfindet, so daß die Waschflüssigkeit auf dem Werkstück schnell verdampft.

Aus der EP-A-0328746 ist ein Verfahren und eine Vorrichtung zum Waschen von Gegenständen bekannt, bei dem bzw. bei der ein Trocknungsgas verwendet wird, um das Wasser von den Oberflächen des zu waschenden Gegenstands zu entfernen, wenn der Gegenstand aus dem Wasser gezogen oder geschoben wird.

Die DE-C-3 733 670 zeigt und beschreibt ein Verfahren und eine Vorrichtung zum Reinigen scheibenförmiger Substrate, bei dem bzw. bei der die Oberflächen der aus dem Wasser herausgezogenen Substrate mit einem Heizelement bestrahlt und mit einer partikelarmen Luft laminarer Strömung umspült werden.

Der Erfindung liegt die Aufgabe zugrunde, ein Verfahren und eine Vorrichtung anzugeben, bei dem die Substrate während des Herausfahrens aus dem Fluidbad schnell, mit geringem Aufwand, ohne Umweltbelastung und ohne Rückstände auf den Substraten getrocknet werden können.

Die Aufgabe wird durch die in den Ansprüchen offenborten Merkmale gelöst.

Bei einem Verfahren zum Trocknen von Substraten, insbesondere von Halbleiter-Wafern, die aus einer Flüssigkeit herausbewegt werden und bei denen sich am Übergang zwischen der Substratoberfläche und der Flüssigkeitsoberfläche ein gekrümmter Meniskusbereich der Flüssigkeit ausbildet, wird die gestellte Aufgabe dadurch gelöst, daß die Oberflächenspannung des gekrümmten Meniskusbereichs (5) - im nachfolgenden auch kurz "Meniskus" genannt - durch örtliche Erhitzung desselben verringert wird.

Die erfindungsgemäße Aufgabe wird bei einem Verfahren der eingangs genannten Art dadurch gelöst, daß beim Ausbringen des Substrate aus einer Flüssigkeit ein sich am Übergang zwischen der Substratoberfläche und der Flüssigkeitsoberfläche ausbildender Meniskus der Flüssigkeit erhitzt wird.

Ein Vorteil der vorliegenden Erfindung besteht darin, daß bei dem erfindungsgemäßen Verfahren die Substrate ohne großen technischen Aufwand, sehr schnell, sehr gründlich und ohne mechanische Beanspruchung während des Heraus-bringens aus dem Flüssigkeitsbad getrocknet werden.

Gemäß einer bevorzugten Ausführungsform der Erfindung wird zur Erhitzung des Meniskus der Flüssigkeit elektromagnetische Strahlung verwendet. Diese besitzt den Vorteil, daß sie sehr leicht erzeugt werden, bestimmte Materialien, wie z.B. eine Haube über dem Flüssigkeitsbad, durchdringen, und sehr leicht auf den Meniskus der Flüssigkeit gebündelt werden kann.

Vorzugsweise weist die elektromagnetische Strahlung Mikrowellen, Infrarotstrahlung und/oder sichtbare Strahlung auf.

Gemäß einer weiteren bevorzugten Ausführungsform der Erfindung werden beim Herausbringen der Substrate aus dem Flüssigkeitsbad die Substrate direkt mit einem Dampf in Kontakt gebracht, der nicht auf dem Substrat kondensiert und der eine Substanz aufweist, die mit der Flüssigkeit mischbar ist, und, wenn sie mit der Flüssigkeit gemischt wird, eine Mischung ergibt, die eine geringere Oberflächenspannung als die Flüssigkeit besitzt. Durch die Kombination des erfindungsgemäßen Verfahrens mit dem aus der eingangs genannten EP-A-0 385 536 bekannten Verfahren ergibt sich für besondere Anwendungsfälle eine zusätzliche Verbesserung und Beschleunigung der Trocknung der Substrate.

Vorteilhafterweise werden die Substrate durch eine messerartige Aushubvorrichtung ausgehoben. Die messerartige Aushubvorrichtung trägt die Substrate, wenn sie aus der Flüssigkeit herausgehoben werden, und zwar an denjenigen Stellen der Substrate, die als letztes die Flüssigkeit verlassen. Tropfen der Flüssigkeit strömen dann über die messerartige Kante der messerartigen Aushubvorrichtung von dem Substrat ab, so daß auch beim Austritt des Substrats aus dem Flüssigkeitsbad, wenn ein Meniskus nicht mehr definiert ist, das Trocknungsverfahren mit gleicher Effizienz fortgesetzt werden kann.

Die Erfindung sowie weitere Vorteile und Ausgestaltungen derselben wird bzw. werden nachfolgend unter Bezugnahme auf eine schematische Darstellung des erfindungsgemäßen Verfahrens erläutert.

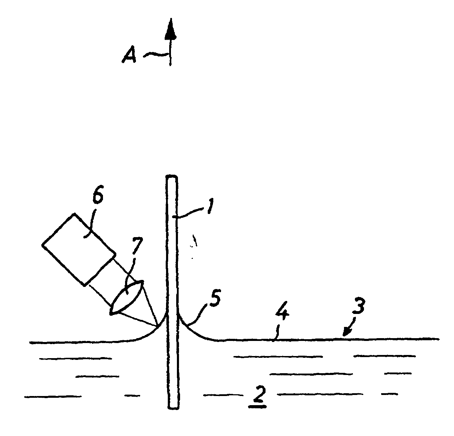

Die Figur zeigt eine schematische Schnittdarstellung des erfindungsgemäßen Trocknungsverfahrens.

Ein Substrat 1, das vorzugsweise ein Halbleiter-Wafer ist, wird aus dem Flüssigkeitsbad 2 in Richtung des Pfeiles A herausgehoben. Dazu kann beispielsweise eine (nicht dargestellte) messerartige Aushubvorrichtung vorgesehen sein. Eine Flüssigkeitsoberfläche 3 des Flüssigkeitsbads 2 weist einen Bereich 4 auf, in dem die Flüssigkeitsoberfläche 3 eben ist. In einem Bereich 5 ist die Flüssigkeitsoberfläche 3 gekrümmt, d. h. es entsteht ein Meniskus der Flüssigkeitsoberfläche 3, weil die Flüssigkeit am Halbleiter-Wafer 1 aufgrund von Adhäsionskräfte anhaftet. Denn die Flüssigkeit benetzt die Oberfläche des Substrats 1, da die von der Substratoberfläche auf die Flüssigkeitsmoleküle wirkenden Anziehungskräfte größer sind als die der Flüssigkeitsmoleküle untereinander.

Eine schematisch dargestellte Energiequelle 6, die vorzugsweise ein Laser oder eine Vorrichtung zum Erzeugen von Mikrowellen, z.B. ein Klystron, ist, ist vorgesehen, um den Meniskus-Abschnitt 5 der Flüssigkeitsoberfläche 3 lokal mittels einer Fokussiereinrichtung 7, die z.B. eine Sammellinse ist, zu erhitzen. Durch eine örtliche Erhitzung im Bereich des Meniskus wird die Oberflächenspannung im an den Wafer 1 angrenzenden, gekrümmten Meniskusbereich 5 gegenüber dem vom Substrat 1 entfernteren ebenen Bereich 4 der Flüssigkeitsoberfläche 3 verringert. Durch die unterschiedlichen Oberflächenspannungen entsteht ein Fluß bzw. eine Strömung von Flüssigkeit von dem Meniskus 5, zum Abschnitt 4 der Flüssigkeitsoberfläche 3 hin, d.h. von dem Substrat 1 weg. Die Flüssigkeit wird dadurch vollständig und schnell vom Substrat 1 abgezogen, wodurch das Substrat 1 ohne weitere Maßnahmen schnell und rückstandsfrei getrocknet wird.

Die Erfindung wurde zuvor anhand eines bevorzugten Ausführungsbeispiels beschrieben. Dem Fachmann sind jedoch zahlreiche Abwandlungen und Ausgestaltungen möglich, ohne daß dadurch der der Erfindung zugrundeliegende Gedanke verlassen wird. Beispielsweise könnte anstelle der oben beschriebenen einseitig angeordneten Energiequelle 6 entsprechende Energiequellen auf allen (vier) Seiten des Substrats 1 angeordnet sein, um die jeweiligen Menisken lokal zu erhitzen. Die in der Figur schematisch dargestellte Linse 7 stellt lediglich ein einfaches Symbol für eine Fokussiereinrichtung dar, und ist insbesondere ein flächig fokussierendes Element, wie z.B. eine Zylinderlinse, um den gesamten Miniskusbereich zu erhitzen.

## Patentansprüche

1. Verfahren zum Trocknen von Substraten (1), insbesondere von Halbleiter-Wafern, die aus einer Flüssigkeit (2) heraus bewegt werden, und bei denen sich am Übergang zwischen der Substratoberfläche und der Flüssigkeitsoberfläche (4) ein gekrümmter Meniskusbereich (5) der Flüssigkeit (2) bildet, **dadurch gekennzeichnet, daß** die Oberflächespannung nur im an das Substrat (1) angrenzenden, gekrümmten Meniskusbereich (5) gegenüber dem vom Substrat (1) entfernteren ebenen Bereich (4) der Flüssigkeitsoberfläche (3) durch örtliche Erhitzung verringert wird.

2. Verfahren nach Anspruch 1, **dadurch gekennzeichnet, daß** eine Strahlung zur örtlichen Erhitzung auf den Meniskus (5) fokussiert wird.

3. Verfahren nach Anspruch 2, **dadurch gekennzeichnet, daß** die Bestrahlung mit elektromagnetischer Strahlung erfolgt.

4. Verfahren nach einem der Ansprüche 2-3, **dadurch gekennzeichnet, daß** die Bestrahlung mit Mikrowellen erfolgt.

5. Verfahren nach einem der Ansprüche 2-4, **dadurch gekennzeichnet, daß** die Bestrahlung mit Infrarotstrahlung erfolgt.

6. Verfahren nach einem der Ansprüche 2-5, **dadurch gekennzeichnet, daß** die Bestrahlung mit Licht, insbesondere im sichtbaren Wellenlängenbereich, erfolgt.

7. Verfahren nach einem der Ansprüche 2-6, **dadurch gekennzeichnet, daß** die Bestrahlung mit Laserlicht erfolgt.

8. Verfahren nach einem der vorhergehenden Ansprüche, **dadurch gekennzeichnet, daß** vor und/oder gleichzeitig mit dem Erhitzen des Meniskus (5) ein sich mit der Flüssigkeit (2) des Meniskus (5) mischender Dampf in Kontakt mit dem Meniskus (5) gebracht wird.

9. Verfahren nach einem der vorhergehenden Ansprüche, **dadurch gekennzeichnet, daß** zum Ausbringen der Substrate (1) eine messerartige Aushubvorrichtung verwendet wird.

10. Verfahren nach einem der vorhergehenden Ansprüche, **dadurch gekennzeichnet, daß** die Flüssigkeit (2) ein Spülfluid, insbesondere Wasser, ist.

11. Verfahren nach einem der vorhergehenden Ansprüche, **dadurch gekennzeichnet, daß** das Substrat (1) ein Halbleiter-Wafer ist.

12. Vorrichtung zum Trocknen von Substraten (1), insbesondere von Halbleiter-Wafern, wobei beim Ausbringen der Substrate (1) aus einer Flüssigkeit (2) am Übergang zwischen der Substratoberfläche und der Flüssigkeitsoberfläche ein gekrümmter Meniskusbereich ausgebildet ist, **dadurch gekennzeichnet, daß** eine Energiequelle (6) zur Verringerung der Oberflächenspannung nur im an das Substrat (1) angrenzenden, gekrümmten Meniskusbereich (5) gegenüber dem vom Substrat (1) entfernteren ebenen Bereich (4) der Flüssigkeitsoberfläche (3) durch örtliche Erhitzung desselben vorgesehen ist.

13. Vorrichtung nach Anspruch 12, **dadurch gekennzeichnet, daß** die Energiequelle (6) eine elektromagnetische Strahlenquelle, eine Mikrowellenquelle, eine Lichtquelle und/oder ein Laser ist.

14. Vorrichtung nach Anspruch 12 oder 13, **gekennzeichnet durch** eine eine Strahlung auf den Meniskus (5) bündelnde Fokussierungseinrichtung (7).

## Claims

1. Method of drying substrates (1), particularly semiconductor wafers, which are moved out of a liquid (2) and in which a curved meniscus region (5) of the liquid (2) forms at the transition between the substrate surface and the liquid surface (4), **characterised in that** the surface tension is reduced, by local heating, only in the curved meniscus region (5), which adjoins the substrate (1), relative to the flat region (4), which is more remote from the substrate (1), of the liquid surface (3).

2. Method according to claim 1, **characterised in that** a radiation for the local heating is focussed on the meniscus (5).

3. Method according to claim 2, **characterised in that** the radiation is carried out within electromagnetic radiation.

4. Method according to one of claims 2 and 3, **characterised in that** the radiation is carried out with microwaves.

5. Method according to one of claims 2 to 4, **characterised in that** the radiation is carried out with infrared radiation.

6. Method according to one of claims 2 to 5, **characterised in that** the radiation is carried out with light, especially in the visible wavelength range.

7. Method according to one of claims 2 to 6, **characterised in that** the radiation is carried out with laser light.

8. Method according to one of the preceding claims, **characterised in that** a steam mixing with the liquid (2) of the meniscus (5) is brought into contact with the meniscus before and/or at the same time as heating of the meniscus (5).

9. Method according to one of the preceding claims, **characterised in that** a knife-like lifting-out device is used for taking out the substrate (1).

10. Method according to one of the preceding claims, **characterised in that** the liquid (2) is a washing fluid, especially water.

11. Method according to one of the preceding claims, **characterised in that** the substrate (1) is a semiconductor wafer.

12. Device for drying substrates (1), especially semiconductor wafers, wherein a curved meniscus region is formed at the transition between the substrate surface and the liquid surface when the substrate (1) is brought out of a liquid (2), **characterised in that** an energy source (6) is provided for reducing the surface tension, by local heating, only in the curved meniscus region (5), which adjoins the substrate (1), relative to the flat region (4), which is more remote from the substrate (1), of the liquid surface (3).

13. Device according to claim 1, **characterised in that** the energy source (6) is an electromagnetic radiation source, a microwave source, a light source and/or a laser.

14. Device according to claim 12 or 13, **characterised by** a focussing device (7) focussing a radiation on the meniscus (5).

## Revendications

1. Procédé de séchage de substrats (1), notamment de plaquettes de semi-conducteurs, qui sont sorties d'un liquide (2) et où se forme à la transition entre la surface du substrat et la surface du liquide (4) une zone de ménisque courbée (5) du liquide (2), **caractérisé en ce que** la tension superficielle est diminuée seulement dans la zone de ménisque courbée (5) avoisinant le substrat (1), par rapport à la zone plane (4) de la surface de liquide (3) plus éloignée du substrat (1), par échauffement local.

2. Procédé selon la revendication 1, **caractérisé en ce qu'**un rayonnement pour l'échauffement local est focalisé sur le ménisque (5).

3. Procédé selon la revendication 2, **caractérisé en ce que** l'irradiation a lieu par un rayonnement électromagnétique.

4. Procédé selon l'une des revendications 2 - 3, **caractérisé en ce que** l'irradiation a lieu avec des micro-ondes.

5. Procédé selon l'une des revendications 2 - 4, **caractérisé en ce que** l'irradiation a lieu par un rayonnement infrarouge.

6. Procédé selon l'une des revendications 2 à 5, **caractérisé en ce que** l'irradiation a lieu avec de la lumière, notamment dans la zone des longueurs d'onde visibles.

7. Procédé selon l'une des revendications 2 - 6, **caractérisé en ce que** l'irradiation a lieu avec de la lumière laser.

8. Procédé selon l'une des revendications précédentes, **caractérisé en ce qu'**avant et/ou simultanément avec l'échauffement du ménisque (5), une vapeur se mélangeant avec le liquide (2) du ménisque (5) est amenée en contact avec le ménisque (5).

9. Procédé selon l'une des revendications précédentes, **caractérisé en ce que** pour l'enlèvement des substrats (1), un dispositif d'enlèvement semblable à un couteau est utilisé.

10. Procédé selon l'une des revendications précédentes, **caractérisé en ce que** le liquide (2) est un fluide de lavage, notamment de l'eau.

11. Procédé selon l'une des revendications précédentes, **caractérisé en ce que** le substrat (1) est une plaquette de semi-conducteur.

12. Dispositif pour le séchage de substrats (1) notamment de plaquettes de semi-conducteur, où est formé lors de la sortie des substrats (1) d'un liquide (2) à la transition entre la surface des substrats et la surface de liquide une zone de ménisque courbée, **caractérisé en ce qu'**il est prévu une source d'énergie (6) pour réduire la tension superficielle seulement dans la zone de ménisque courbée (5) avoisinant le substrat (1) par rapport à la zone plane (4) de la surface de liquide (3) plus éloignée du substrat (1) par un échauffement local de celle-ci.

13. Dispositif selon la revendication 12, **caractérisé en ce que** la source d'énergie (6) est une source de rayonnement électromagnétique, une source de micro-ondes, une source de lumière et/ou un laser.

14. Dispositif selon la revendication 12 ou 13, **caractérisé par** une installation de focalisation (7) focalisant un rayonnement sur le ménisque (5).
